# EUROPEAN PATENT APPLICATION

(11) **EP 4 506 983 A1**
(43) Date of publication of application: **12.02.2025**
(21) Application number: 23190284.2
(22) Date of filing: 08.08.2023
(51) Int. Cl.: H01L 21/67, H01J 37/32

(54) **A CLEANING SYSTEM AND A METHOD FOR CLEANING A CARRIER FOR SEMICONDUCTOR SUBSTRATES OR AT LEAST A SURFACE OF THE CARRIER**

(71) Applicant: Brooks Automation (Germany) GmbH, 78256 Steißlingen (DE)
(72) Inventor: YANG, Po-Yu, 78315 Radolfzell (DE); GHASEMIANSAFAEI, Mandana, 78224 Singen (DE); BAUMEISTER, Cornelia, 78647 Trossingen (DE); MEIER, Karl, 8240 Thayngen (CH); SCHWETZ, Michael, 8400 Winterthur (CH)
(74) Representative: Dehns Germany Partnerschaft mbB

(57) **Abstract**

The present invention refers to a cleaning system (100) for cleaning a carrier (105) for semiconductor substrates or at least a surface of the carrier (105), comprising: a first chamber (110) and a second chamber (120), wherein the first chamber (110) and the second chamber (120) are in fluid-communication with each other, wherein the second chamber (120) is configured to accommodate the carrier (105); an input fluid supply (130) configured to provide an input fluid (135) to the first chamber (110); a radiation source (140) configured to provide radiation of at least one predetermined wavelength within the first chamber (110) and configured to create a cleaning fluid (145) comprising a plasma and/or ozone and/or atomic oxygen by means of exposing the input fluid (135) in the first chamber (110) to the radiation; a cleaning fluid transfer unit (150) configured to transfer the cleaning fluid from the first chamber (110) to the second chamber (120) for cleaning the carrier (105) or at least the surface of the carrier (105) provided in the second chamber (120) and configured to subject the carrier (105) or at least the surface of the carrier (105) to the cleaning fluid in the second chamber (120).

## Description

The present invention relates to a cleaning system and to a method for cleaning a carrier for semiconductor substrates or at least a surface of the carrier.

### Background of the invention

Substrates used in semiconductor fabs, such as wafers or reticles can be stored and handled in plastic carriers such as FOUPs (Front Opening Unified Pod) or Reticle Pods, which usually comprise plastics as their basic material. These basic materials can contain inherent impurities. Additional impurities can be absorbed from the fab environment during usage and handling of the carriers. The carriers particularly need to be cleaned before usage and at regular intervals during usage.

Conventional cleaning technologies for removal of chemical contaminations can e.g. be based on use of water, chemical solvents or vacuum technologies. However, by means of these conventional cleaning technologies, impurities can oftentimes only be removed from surface-adjacent regions of the material. It is hardly possible to remove impurities from deeper areas such as pores and micro-features of the plastic materials. The impurities further inside of the plastic material can remain inside the material during the cleaning process and can subsequently start to outgas after the cleaning process, especially while the carriers contain substrates.

It is therefore desirable to provide improved means for cleaning a carrier or at least a surface of the carrier for semiconductor substrates.

### Summary of the invention

The present invention relates to a cleaning system and to a method for cleaning a carrier for semiconductor substrates or at least a surface of the carrier with the features of the independent claims. Advantageous embodiments are the subject-matter of the dependent claims and of the following description.

The method according to the present invention can particularly be performed using the cleaning system according to the present invention. Embodiments and advantages of the cleaning system and of the method according to the present invention shall arise from the present description in an analogous manner.

The carrier is particularly configured for storing, handling, or transporting of semiconductor substrates like wafers or reticles and can e.g. be provided as a FOUP (Front Opening Unified Pod) or a Reticle Pod. The carrier is advantageously made of a plastics material. Carriers made of suitable plastics materials are light and robust in their handling and provide excellent protection from external contamination.

The cleaning system comprises a first chamber and a second chamber, wherein the first chamber and the second chamber are in fluid-communication with each other. For example, the first chamber and the second chamber can be linked by means of a pipe, tube, duct, etc. Each one of the first chamber and the second chamber can comprise an inlet and an outlet. The outlet of the first chamber can particularly be connected with the inlet of the second chamber.

The second chamber is configured to accommodate the carrier. During implementation of the present method, the carrier is provided in the second chamber, e.g. manually or automatically, e.g. by means of a robot.

The cleaning system comprises an input fluid supply configured to provide an input fluid to the first chamber. For example, the input fluid supply can be provided in the inlet of the first chamber. In the course of the present method, the input fluid is provided to the first chamber. In particular, a gas or a mixture of gases or several mixtures of gases can be provided as the input fluid.

The cleaning system further comprises a radiation source configured to provide radiation of at least one predetermined wavelength within the first chamber and configured to create a cleaning fluid comprising a plasma and/or ozone and/or atomic oxygen by means of exposing the input fluid in the first chamber to the radiation. In the course of the present method, a corresponding cleaning fluid is created within the first chamber.

The radiation source can particularly be provided inside or within the first chamber, especially at one or several positions within the first chamber, such that a large amount of the input fluid inside the chamber can be exposed to the corresponding radiation. The input fluid can then interact with the corresponding radiation or the radiation can induce a certain reaction of the input fluid such that plasma and/or ozone and/or atomic oxygen is created.

For example, specific atoms or molecules of the input fluid can be ionised by means of radiation with a specific wavelength such that a corresponding plasma can be created, i.e. a fluid comprising ions, electrons and neutral atoms and/or molecules.

Alternatively or additionally, radiation with another specific wavelength can dissociate oxygen molecules of the input fluid into atomic oxygen, especially into triplet atomic oxygen, i.e. atomic oxygen in a ground state of its electron configuration (³P). This triplet atomic oxygen can react with oxygen molecules to create ozone.

Furthermore, radiation with yet another specific wavelength can also dissociate ozone molecules into oxygen molecules and atomic oxygen, especially into singlet atomic oxygen, i.e. atomic oxygen in a first exited state of the electron configuration (¹D).

The cleaning system further comprises a cleaning fluid transfer unit configured to transfer the cleaning fluid from the first chamber to the second chamber for cleaning the carrier or at least the surface of the carrier provided in the second chamber and configured to subject the carrier or at least the surface of the carrier to the cleaning fluid in the second chamber. The cleaning fluid is correspondingly transferred from the first chamber to the second chamber and the carrier or at least the surface of the carrier is cleaned in the second chamber by means of the cleaning fluid.

The carrier in the second chamber can particularly be flushed with the cleaning fluid. The chemical reactivity and/or kinetic energy of specific components of the cleaning fluid is expediently used for removal of contaminants from the carrier. For example, ions of the corresponding plasma can be used for an ion bombardment of the carrier material. Atoms, radicals and molecules can be broken off the carrier material by means of this ion bombardment and can then be removed from the second chamber. Alternatively or additionally, highly reactive oxygen molecules and/or highly reactive atomic oxygen can react with contaminants on the carrier material. Strong oxidation power of atomic oxygen can e.g. cause reactions with organic contaminants on the carrier surface. Polymer chains of the organic contaminants can be split by UV radiation of the corresponding plasma. Free chemical compounds (contaminants) can e.g. combine with atomic oxygen radicals. Correspondingly formed bonds can prevent reunion of the polymer fragments. Resulting short-chain and volatile substances can then be removed.

The present invention is based on the realisation that a cleaning fluid comprising a plasma and/or ozone and/or atomic oxygen allows efficient cleaning of the carrier material, especially a porous plastics material, and removal of organic contamination from the carrier material.

Since energy and heat of the radiation source necessary for creating the corresponding cleaning fluid can have negative effects on the carrier itself, e.g. discoloring or damage of the carrier material, the present invention further suggests to create the corresponding cleaning fluid in the first chamber, which is separated from the second chamber, in which the carrier is accommodated. For example, irradiation from the radiation source can have negative effects on organic materials in general, for example the plastics materials that the carrier is made of. Organic compounds could decompose in ultraviolet light. High energy radiation could excite electrons in the sigma bonding molecular orbitals and break carbon-carbon bonds in the carrier material. By means of creating the cleaning fluid in the first chamber and cleaning the carrier in the second chamber, the carrier can be protected from these kinds of negative effects of the radiation source.

The present invention therefore allows efficient cleaning of a substrate carrier or at least of the surface of the carrier from organic contamination. Impurities or contamination can be efficiently and reliably removed from deeper areas the material of the carrier, i.e. areas further away from surfaces of the material, especially a plastics material. Deeper and more efficient cleaning of micro features such as cracks, cavities and pores can be performed. Outgassing of impurities after the cleaning process can thus be delayed and reduced. Cleaning intervals can therefore be increased, thereby increasing usage time of a carrier.

The cleaning process according to the present invention can easily be combined with conventional cleaning processes. For example, first of all, a cleaning process with water can be performed in order to remove NH₃, acids, amines and particle contamination from the surface of the carrier. A drying sequence e.g. with clean dry air (CDA) can be performed subsequently. Following this, the cleaning process according to the present invention can advantageously be performed.

Parameters of the cleaning process can easily be adjusted or optimised to improve the cleaning effect, e.g. depending on the specific type of carrier or on the specific carrier material. For example, one or several of the following parameters can be adjusted: energy of the plasma, reaction time, moisture level of the input fluid, O₂ content of the input fluid, gas composition of the input fluid, power, working distance, pressure, plasma distribution, combination of different cleaning processes, process step order, etc.

It is e.g. also possible to provide different input fluids with different components and different radiation with different wavelengths, either simultaneously or sequentially, to take advantage of the respective benefits. For example, several first chambers can be provided, wherein different cleaning fluids are created in these first chambers and wherein these different cleaning fluids are transported to the second chamber for cleaning the carrier.

According to an embodiment, the first chamber comprises an outlet and the second chamber comprises an inlet. The inlet of the second chamber is connected with the outlet of the first chamber via a passageway, the diameter of which is smaller than the diameter of the first and second chamber. Hereby, an effective separation between the two chambers is provided, such that any direct effects of the usage of radiation in the first chamber on the contents of the second chamber, especially a carrier to be cleaned, can be minimised.

According to an embodiment, the passageway can be closed during the generation of the cleaning fluid. For transferring the cleaning fluid from the first chamber to the second chamber, the passageway can be opened. By keeping the passageway in a closed state during the generation of a cleaning fluid by means of radiation, and opening the passageway after generation of a sufficient amount of cleaning fluid, the transmittance of radiation into the second chamber can be further minimised or completely prevented. For example, a specific mechanism can be provided in the passageway, e.g. in the vicinity of the outlet of the first chamber or the inlet of the second chamber, in order to close and open the passageway. This mechanism can for example comprise a door, a window or the like, which is expediently impermeable to the radiation provided in the first chamber. However, the cleaning system can also be provided and operated without a door or window in the passageway by controlling parameters in both chambers.

According to an embodiment, the cleaning transfer unit comprises a mechanical pump for creating a vacuum in the second chamber. Since the first chamber and the second chamber are in fluid-communication with each other, the cleaning fluid created in the first chamber can be sucked into the second chamber by means of the pressure difference between the first chamber and the second chamber. This way, a flux or stream of the cleaning fluid can expediently be created for flushing the carrier with the cleaning fluid.

According to an embodiment, the second chamber comprises an outlet, wherein the mechanical pump is provided in the outlet of the second chamber. This way, the cleaning transfer unit or the mechanical pump, repetitively, can be provided in a space saving manner.

According to an embodiment, the mechanical pump is further configured to remove contaminants from the second chamber, particularly contaminants removed from the carrier material by means of the cleaning fluid. When providing the mechanical pump in the outlet of the second chamber, the contaminants can expediently be removed via this outlet from the second chamber.

According to an embodiment, the input fluid supply is configured to provide at least one of the following gases or gas mixtures as the input fluid to the first chamber: air and/or molecular oxygen and/or argon and/or helium. Air, molecular oxygen or a mixture therefore can particularly be used for creating an oxygen plasma and/or ozone and/or atomic oxygen. Argon can expediently be used for creating an argon plasma. Argon can further support other cleaning agents as a carrier gas. Helium can expediently be used for creating a helium plasma. Furthermore, various other gases can be used additionally or alternatively to the above referenced gases as the input fluid. The composition of the input fluid can also be varied and adjusted, e.g. depending on the specific type of carrier or on the specific carrier material, in order to adapt the cleaning process and in order to improve the cleaning effect.

According to an embodiment, the radiation source comprises a radio frequency radiation source for providing a radio frequency radiation with a predetermined radio wavelength configured to create a plasma from the input fluid. The radiation source can therefore expediently be provided as a radio frequency plasma generator. The predetermined radio wavelength can for example be in the range between 7500 m (corresponding to a frequency of roughly 40 kHz) and 0.1 m (corresponding to a frequency of roughly 3 GHz).

According to an embodiment, the radio frequency radiation source is configured to create an oxygen plasma as the cleaning fluid comprising oxygen ions, electrons, and atomic oxygen, particularly singlet atomic oxygen. For this purpose, the input fluid expediently comprises air and/or molecular oxygen. The molecular oxygen is separated into electrons, oxygen ions, and atomic oxygen, i.e. oxygen radicals, by means of the radio frequency radiation. The highly reactive oxygen molecules and radicals can react with the contaminants on the carrier material. The polymer chains of the organic contaminants can be split by UV radiation of the oxygen plasma. The free chemical contaminants can react with oxygen radicals from the plasma.

According to an embodiment, the radio frequency radiation source is configured to create an argon plasma as the cleaning fluid comprising argon ions and electrons. For this purpose, the input fluid expediently comprises argon. The argon plasma can expediently cause an ion bombardment on the carrier material. Atoms, radicals and molecules can be broken off the carrier material by means of the kinetic energy of the argon ions of the argon plasma. Since the ion bombardment can also etch the carrier material, the processing time can expediently be adjusted in order to prevent unwanted side effects such as a roughening of the carrier surface.

According to an embodiment, the radiation source comprises a first ultraviolet radiation source for providing a first ultraviolet radiation with a first predetermined ultraviolet wavelength, especially 184.9 nm or at least essentially 184.9 nm, configured to create ozone from molecular oxygen. For this purpose, the input fluid expediently comprises air and/or molecular oxygen. In particular, by means of this radiation with the first predetermined ultraviolet wavelength, an oxygen molecule O₂ can be dissociated into two triplet oxygen atoms O(³P). These triplet oxygen atoms O(³P) can then react with oxygen molecule O₂ to create ozone molecules O₃.

According to an embodiment, the radiation source comprises a second ultraviolet radiation source for providing a second ultraviolet radiation with a second predetermined ultraviolet wavelength, especially 253.7 nm or at least essentially 253.7 nm, configured to create atomic oxygen, especially singlet atomic oxygen, from ozone. For this purpose, the input fluid could comprise ozone. Expediently, the ozone created in the first chamber by means of the first ultraviolet radiation with the first predetermined ultraviolet wavelength is dissociated into atomic oxygen by means of the second UV radiation with the second predetermined ultraviolet wavelength. In particular, by means of this radiation with the second predetermined ultraviolet wavelength, ozone molecules O₃ can be dissociated into oxygen molecules O₂ and singlet atomic oxygen O(¹D). The strong oxidation power of singlet atomic oxygen can cause reactions with organic contaminants in the carrier material in the second chamber. Chain scission of molecules can happen. Resulting volatile molecules such as CO₂, H₂O and O₂ can be flushed away and removed from the second chamber.

Further advantages and embodiments of the invention are specified in the description and the associated drawings.

It goes without saying, that the features named above and still to be explained below can be used not only in the combination indicated respectively, but also in other combinations or in a stand-alone manner, without going beyond the scope of the present invention. Especially, plasma and/or ozone and/or atomic oxygen as cleaning fluids can be used separately, simultaneously or subsequently to one another in any desired or expedient order.

The invention is illustrated schematically in the drawings on the basis of exemplary embodiments and will be described in detail in the following with reference to the drawings.

### Brief description of the drawings

- Fig. 1: schematically shows an embodiment of a cleaning system according to the invention configured to perform an embodiment of a method according to the invention.
- Fig. 2: schematically shows an embodiment of a cleaning system according to the invention configured to perform an embodiment of a method according to the invention.

### Detailed description of the drawings

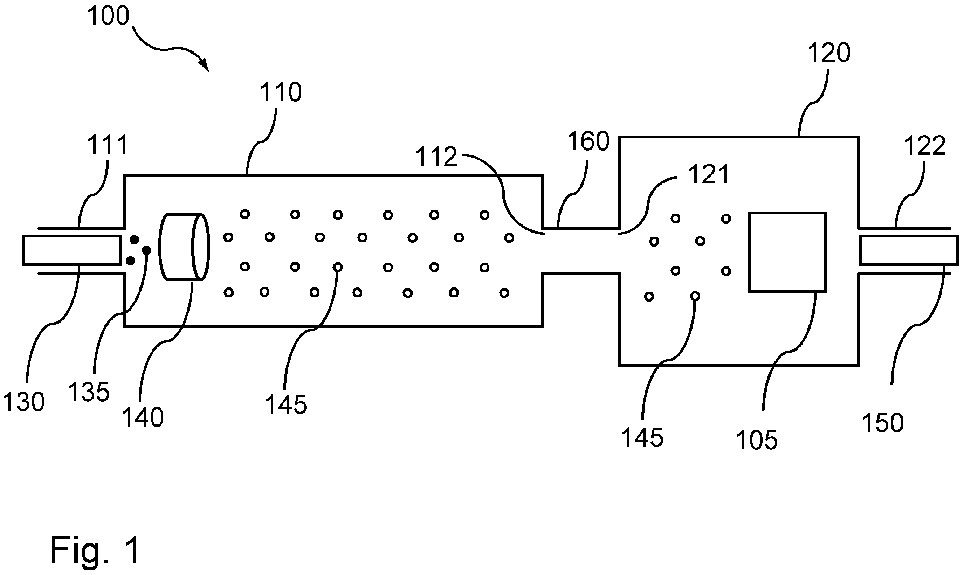

Fig. 1 schematically shows an embodiment of a cleaning system 100 according to the present invention, which is configured to perform an embodiment of a method according to the present invention.

The cleaning system 100 is provided for cleaning a carrier 105 for storing, handling, or transporting semiconductor substrates like or at least a surface of the carrier 105. The carrier 105 can e.g. be provided as a Front Opening Unified Pod, FOUP, and can be made of a plastic material.

For this purpose, the cleaning system 100 comprises a first chamber 110 and a second chamber 120, which are in fluid-communication with each other. The first chamber 110 comprises an inlet 111 and an outlet 112. Correspondingly, the second chamber 120 also comprises an inlet 121 and an outlet 122. The outlet 112 of the first chamber 110 and the inlet 121 of the second chamber 120 are connected with each other via a passageway 160, thereby establishing the fluid-communication of the first chamber 110 and the second chamber 120. Advantageously, the diameter of passageway 160 is substantially smaller than that of the first and second chamber.

The second chamber 120 is configured to accommodate the carrier 105. For example, the carrier 105 can be provided manually or automatically by means of a robot in the second chamber 120.

An input fluid supply 130 is configured to provide an input fluid 135 to the first chamber 110. For example, the input fluid supply 130 can be provided in the inlet 111 of the first chamber 110. The input fluid 135 provided to the first chamber 110 can e.g. comprise molecular oxygen and argon.

A radiation source 140 is configured to provide radiation of at least one predetermined wavelength within the first chamber 110 and to create a cleaning fluid 145 comprising a plasma by means of exposing the input fluid 135 in the first chamber 110 to the radiation.

In the example of Fig. 1, the radiation source 140 is embodied as a radio frequency radiation source or radio frequency plasma generator for providing a radio frequency radiation with a predetermined radio wavelength configured to create a plasma from the input fluid 135. The predetermined radio wavelength can for example be in the range between 7500 m (corresponding to a frequency of roughly 40 kHz) and 0.1 m (corresponding to a frequency of roughly 3 GHz). The RF plasma generator 140 is provided inside the first chamber 110 in the vicinity of the inlet 111 such that the input fluid 135 ejected from the input fluid supply 130 passes through the plasma generator 140. In the course of this passing, the input fluid 135 is exposed to the RF radiation emitted by the plasma generator 140 such that the cleaning fluid 145 is created.

In particular, oxygen molecules in the input fluid 135 are affected by means of the radio frequency radiation, such that an oxygen plasma is created comprising electrons, oxygen ions, and atomic oxygen, particularly singlet atomic oxygen. Further, argon atoms in the input fluid 135 are affected by means of the radio frequency radiation, thereby creating an argon plasma comprising electrons and argon ions. The created cleaning fluid 145 therefore comprises electrons, oxygen ions, singlet atomic oxygen, and argon atoms and can further comprise neutral molecules oxygen and argon ions, which were not affected by the radio frequency radiation.

A cleaning fluid transfer unit 150 is configured to transfer the cleaning fluid 145 from the first chamber 110 to the second chamber 120 for cleaning the carrier 105 provided in the second chamber 120 and to subject the carrier 105 to the cleaning fluid 145 in the second chamber 120.

For example, the cleaning fluid transfer unit 150 can be provided as a mechanical pump for creating a vacuum in the second chamber 120. This mechanical pump 150 can e.g. be provided in the outlet 122 of the second chamber 120. Since the first chamber 110 and the second chamber 120 are in fluid-communication with each other, the cleaning fluid 145 created in the first chamber 110 can be sucked into the second chamber 120 by means of the pressure difference between the first chamber 110 and the second chamber 120. This way, a flux or stream of the cleaning fluid 145 can be created for flushing the carrier 105 in the second chamber 120 with the cleaning fluid.

By means of the chemical reactivity and kinetic energy of the components of the cleaning fluid 145, contaminants can be removed from the carrier material. In particular, the highly reactive oxygen molecules and radicals of the oxygen plasma can react with the contaminants on the carrier material. The polymer chains of the organic contaminants can be split by the UV radiation of the oxygen plasma. The free chemical contaminants can react with oxygen radicals from the plasma. Correspondingly formed bonds can prevent reunion of the polymer fragments. Further, an ion bombardment on the carrier material with argon ions from the argon plasma can be crated. Atoms, radicals and molecules can be broken off the carrier material by means of the kinetic energy of the argon ions. By means of the mechanical pump 150, these kinds of contaminants, which are removed from the carrier material, can be removed from the second chamber 120.

The invention therefore allows to create a cleaning fluid 145 comprising a plasma and to efficiently clean the carrier 105 by means of this cleaning fluid 145, thereby removing organic contamination from the carrier material even in deeper layers inside the material. By means of creating the corresponding cleaning fluid 145 inside the first chamber 110, which is separated from the second chamber 120 in which the carrier 105 is accommodated, the carrier 105 can be protected from the energy and heat of the radio frequency radiation source 140, which can have negative effects on the carrier 105 itself. By means of providing the passageway 160 with a small diameter, especially in relation to that of the first and second chamber, transmission of radiation from the first chamber to the second chamber during generation of a cleaning fluid can be minimised.

For example, the passageway 160 can be closed during the creation of the cleaning fluid. For transferring the cleaning fluid from the first chamber 110 to the second chamber 120, the passageway 160 can for example be opened. This way, transmittance of radiation into the second chamber 120 can be further minimised or completely prevented. It is possible to provide a specific mechanism in the passageway 160 in order to close and open the passageway 160 accordingly. For example, this mechanism can comprise a door or a window etc. Alternatively, the passageway 160 can be provided without a window or door, and the cleanings system can accordingly be operated by controlling parameters in both chambers.

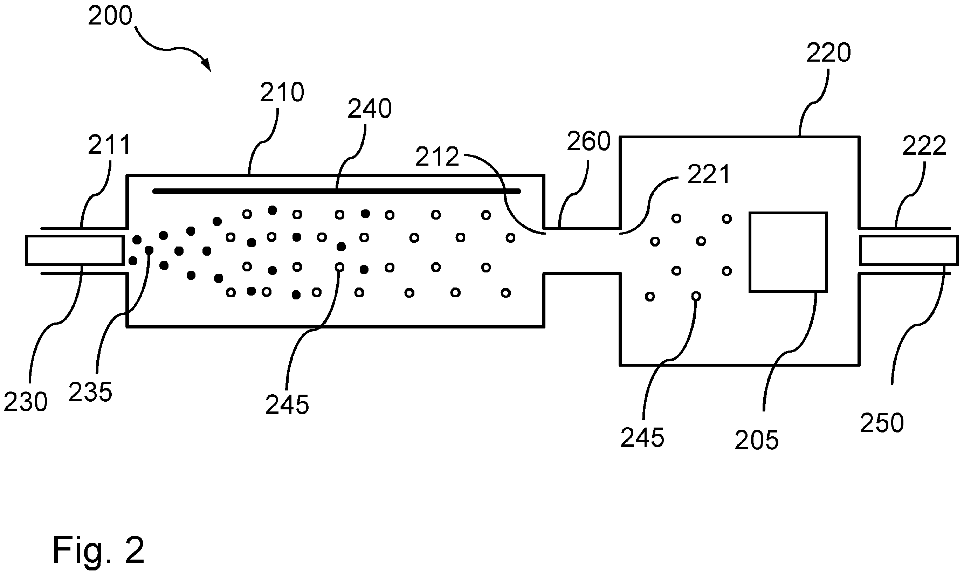

Alternatively or additionally to the radio frequency radiation source 140, it is also possible to provide an ultraviolet radiation source for creating a cleaning fluid comprising ozone and atomic oxygen, as shall be explained hereafter with reference to Fig. 2.

Fig. 2 schematically shows an embodiment of a cleaning system 200 according to the present invention configured to perform an embodiment of a method according to the present invention.

In accordance with the cleaning system 100 of Fig. 1, the cleaning system 200 shown in Fig. 2 also comprises a first chamber 210 and a second chamber 220 in fluid-communication with each other, wherein the second chamber 220 is configured to accommodate the carrier 205. The first chamber 210 comprises an inlet 211 and an outlet 212 and the second chamber 220 comprises an inlet 221 and an outlet 222, wherein the outlet 212 of the first chamber 210 and the inlet 221 of the second chamber 220 are connected with each other via a passageway 260. Again, as described in connection with figure 1, by providing passageway 260 with a small diameter relative to that of the first and second chamber, transmission of radiation from the first chamber to the second chamber during the generation of cleaning fluid can be minimised.

An input fluid supply 230 is provided in the inlet 211 of the first chamber 210 and is configured to provide an input fluid 235 to the first chamber 210. In the example of Fig. 2, this input fluid 235 comprises molecular oxygen.

A radiation source 240 is provided as an ultraviolet radiation source for providing a first ultraviolet radiation with a first predetermined ultraviolet wavelength of 184.9 nm and for providing a second ultraviolet radiation with a second predetermined ultraviolet wavelength of 253.7 nm to create a cleaning fluid 245 comprising ozone and atomic oxygen.

By means of this first UV radiation with the wavelength of 184.9 nm, oxygen molecules O₂ in the input fluid 235 are dissociated into triplet oxygen atoms O(³P). These triplet oxygen atoms O(³P) react with oxygen molecules O₂ of the input fluid 235 to create ozone molecules O₃. By means of the second UV radiation with the wavelength of 253.7 nm, the ozone molecules O₃ are dissociated into oxygen molecules O₂ and singlet atomic oxygen O(¹D).

Therefore, the created cleaning fluid 245 comprises singlet atomic oxygen O(¹D) as well as triplet oxygen atoms O(³P), ozone molecules and oxygen molecules, which were not affected by the corresponding UV radiation.

A cleaning fluid transfer unit 250, particularly a mechanical pump provided in the outlet 222 of the second chamber 220 for creating a vacuum in the second chamber 220, is configured to transfer the cleaning fluid 245 from the first chamber 110 to the second chamber 220 for cleaning the carrier 205 and to subject the carrier 205 to the cleaning fluid 245 in the second chamber 220. By means of the mechanical pump 250, a flux or stream of the cleaning fluid 245 can be created for flushing the carrier 205 in the second chamber 220.

The strong oxidation power of the singlet atomic oxygen O(¹D) causes reactions with organic contaminants in the plastic material of the carrier 205. Chain scission of molecules can happen. Resulting volatile molecules such as CO₂, H₂O and O₂ are flushed away and removed from the second chamber 220 by means of the mechanical pump 250.

The invention therefore allows to create a cleaning fluid 245 comprising ozone and atomic oxygen to efficiently clean the carrier 205 and to remove organic contamination even in deep layers of the plastic carrier material. The ultraviolet radiation necessary for creating this kind of cleaning fluid 245 can be harmful to the carrier 205 and cause e.g. discoloration or damage of the carrier material. However, by means of creating the corresponding cleaning fluid 245 inside the first chamber 210, the carrier 205 accommodated in the second chamber 220 can be protected from these harmful effects of the ultraviolet radiation source 240. As described in connection with Fig. 1, the passageway 260 can be closed during the creation of the cleaning fluid and can be opened for transferring the cleaning fluid from the first chamber 210 to the second chamber 220 for further minimising or completely preventing transmittance of UV radiation into the second chamber 220.

It is to be understood that the embodiments shown in Fig. 1 and Fig. 2 can also be combined. For example, both a radio frequency plasma generator and an ultraviolet radiation source can commonly be provided in the first chamber to create a cleaning fluid comprising plasma, ozone and atomic oxygen. It is also possible to provide several first chambers. For example, a radio frequency plasma generator can be provided in a first one of these first chambers for creating a first cleaning fluid comprising a plasma. A UV radiation source can e.g. be provided in a second one of these first chambers for creating a second cleaning fluid comprising ozone and atomic oxygen. These first and second cleaning fluids can then be transferred to the second chamber for cleaning the carrier.

The present invention therefore allows efficient cleaning of a substrate carrier or at least of the surface of the carrier from organic contamination, expediently not only from outer layers but also from deeper layers inside the material of the carrier.

## Claims

1. A cleaning system (100, 200) for cleaning a carrier (105, 205) for semiconductor substrates or at least a surface of the carrier (105, 205), comprising:
a first chamber (110, 210) and a second chamber (120, 220), wherein the first chamber (110, 210) and the second chamber (120, 220) are in fluid-communication with each other, wherein the second chamber (120, 220) is configured to accommodate the carrier (105, 205);
an input fluid supply (130, 230) configured to provide an input fluid (135, 235) to the first chamber (110, 210);
a radiation source (140, 240) configured to provide radiation of at least one predetermined wavelength within the first chamber (110, 210) and configured to create a cleaning fluid (145, 245) comprising a plasma and/or ozone and/or atomic oxygen by means of exposing the input fluid (135, 235) in the first chamber (110, 210) to the radiation;
a cleaning fluid transfer unit (150, 250) configured to transfer the cleaning fluid from the first chamber (110, 210) to the second chamber (120, 220) for cleaning the carrier (105, 205) or at least the surface of the carrier (105, 205) provided in the second chamber (120, 220) and configured to subject the carrier (105, 205) or at least the surface of the carrier (105, 205) to the cleaning fluid in the second chamber (120, 220).

2. The system according to claim 1, wherein the first chamber (110, 210) comprises an outlet (112, 212), wherein the second chamber (120, 220) comprises an inlet (121, 221), wherein the inlet (121, 221) of the second chamber (120, 220) is connected with the outlet (112, 212) of the first chamber (110, 210) via a passageway (160, 260), wherein a diameter of the passageway (160, 260) is smaller than a diameter of the first chamber (110, 210) and a diameter of the second chamber (120, 220).

3. The system according to claim 1 or 2, wherein the cleaning transfer unit (150, 250) comprises a mechanical pump for creating a vacuum in the second chamber (120, 220).

4. The system according to claim 3, wherein the second chamber (120, 220) comprises an outlet (121, 222), wherein the mechanical pump (150, 250) is provided in the outlet (122, 222) of the second chamber (120, 220).

5. The system according to claim 3 or 4, wherein the mechanical pump (150, 250) is further configured to remove contaminants from the second chamber (120, 220).

6. The system according to any one of the preceding claims, wherein the input fluid supply (130, 230) is configured to provide at least one of the following gases or gas mixtures as the input fluid (135, 235) to the first chamber (110, 210):
air;
molecular oxygen;
argon;
helium.

7. The system according to any one of the preceding claims, wherein the radiation source (140) comprises a radio frequency radiation source for providing a radio frequency radiation with a predetermined radio wavelength configured to create a plasma (145) from the input fluid (135).

8. The system according to claim 7, wherein the radio frequency radiation source (140) is configured to:
create an oxygen plasma as the cleaning fluid (145) comprising oxygen ions, electrons and atomic oxygen; and/or
create an argon plasma as the cleaning fluid (145) comprising argon ions and electrons.

9. The system according to any one of the preceding claims, wherein the radiation source (245) comprises:
a first ultraviolet radiation source for providing a first ultraviolet radiation with a first predetermined ultraviolet wavelength, especially 184.9 nm or at least essentially 184.9 nm, configured to create ozone from molecular oxygen; and/or
a second ultraviolet radiation source for providing a second ultraviolet radiation with a second predetermined ultraviolet wavelength, especially 253.7 nm or at least essentially 253.7 nm, configured to create atomic oxygen, especially singlet atomic oxygen, from ozone.

10. A method for cleaning a carrier (105, 205) for semiconductor substrates or at least a surface of the carrier (105, 205) by means of a cleaning system (100, 200), wherein the cleaning system (100, 200) comprises a first chamber (110, 210) and a second chamber (120, 220) and wherein the first chamber (110, 210) and the second chamber (120, 220) are in fluid-communication with each other, the method comprising the steps of:
providing the carrier (105, 205) in the second chamber (120, 220);
providing an input fluid (135, 235) to the first chamber (110, 210);
providing radiation of at least one predetermined wavelength within the first chamber (110, 210);
creating a cleaning fluid (145, 245) comprising a plasma and/or ozone and/or atomic oxygen by means of exposing the input fluid (135, 235) in the first chamber (110, 210) to the radiation;
transferring the cleaning fluid (145, 245) from the first chamber (110, 210) to the second chamber (120, 220);
cleaning the carrier (105, 205) or at least the surface of the carrier (105, 205) by means of the cleaning fluid (145, 245) and subjecting the carrier (105, 205) or at least the surface of the carrier (105, 205) to the cleaning fluid (145, 245) in the second chamber (120, 220).

11. The method according to claim 10, wherein the first chamber (110, 210) comprises an outlet (112, 212), wherein the second chamber (120, 220) comprises an inlet (121, 221), wherein the inlet (121, 221) of the second chamber (120, 220) is connected with the outlet (112, 212) of the first chamber (110, 210) via a passageway (160, 260), wherein the method further comprises the steps of:
closing the passageway (160, 260) during the creating of the cleaning fluid (145, 245); and
opening the passageway (160, 260) during the transferring of the cleaning fluid (145, 245) from the first chamber (110, 210) to the second chamber (120, 220).

12. The method according to claim 10 or 11, wherein the step of transferring the cleaning fluid (145, 245) from the first chamber (110, 210) to the second chamber (120, 220) comprises creating a vacuum in the second chamber (120, 220), especially by means of a mechanical pump (150, 250).

13. The method according to claim 10 to 12, further comprising removing contaminants from the second chamber (120, 220), especially by means of a mechanical pump (150, 250).

14. The method according to any one of the claims 10 to 13, wherein at least one of the following gases or gas mixtures is provided as the input fluid (135, 235) to the first chamber (110, 210):
air;
oxygen;
argon;
helium.

15. The method according to any one of the claims 10 to 14, wherein the step of providing the radiation within the first chamber (110, 210) comprises providing a radio frequency radiation with a predetermined radio wavelength for creating a plasma from the input fluid (135, 235).

16. The method according to claim 15, wherein the step of creating the cleaning fluid (145) comprises:
creating an oxygen plasma as the cleaning fluid (145) comprising oxygen ions, electrons and atomic oxygen by means of exposing molecular oxygen as the input fluid (135) to radio frequency radiation with a first predetermined radio wavelength; and/or
creating an argon plasma as the cleaning fluid (145) comprising argon ions and electrons by means of exposing argon as the input fluid (135) to radio frequency radiation with a second predetermined radio frequency.

17. The method according to any one of the claims 10 to 16, wherein the step of providing the radiation within the first chamber (210) comprises:
providing an ultraviolet radiation with a first predetermined ultraviolet wavelength, especially 184.9 nm or at least essentially 184.9 nm, for creating ozone from molecular oxygen; and/or
providing an ultraviolet radiation with a second predetermined ultraviolet wavelength, especially 253.7 nm or at least essentially 253.7 nm, for creating atomic oxygen, especially singlet atomic oxygen, from ozone.
